# EUROPÄISCHE PATENTSCHRIFT

(11) **EP 1 219 150 B1**
(45) Veröffentlichungstag und Bekanntmachung des Hinweises auf die Patenterteilung: **05.03.2003**
(21) Anmeldenummer: 00979397.7
(22) Anmeldetag: 29.09.2000
(51) Int. Cl.: H05K 3/00, B23K 26/00

(54) **VERFAHREN UND EINRICHTUNG ZUM LASERBOHREN VON LAMINATEN**
METHOD AND DEVICE FOR LASER DRILLING LAMINATES
PROCEDE POUR PERCER DES LAMINES AU LASER

(30) Priorität: 30.09.1999 DE 19947027
(43) Veröffentlichungstag der Anmeldung: 03.07.2002
(73) Patentinhaber: SIEMENS AKTIENGESELLSCHAFT, 80333 München (DE)
(72) Erfinder: VAN PUYMBROECK, Jozef, B-8020 Oostkamp (BE); HEERMAN, Marcel, B-9200 Merelbeke (BE); DE STEUR, Hubert, B-9031 Drongen (BE)
(86) Internationale Anmeldenummer: DE0003424
(87) Internationale Veröffentlichungsnummer: WO01026435

(56) Entgegenhaltungen:
- DE-A- 19 719 700
- DE-A- 19 824 225
- GB-A- 2 338 201
- US-A- 4 839 497
- US-A- 5 593 606
- T.R. FLETCHER: "EFFICIENT ABLATION OF AN ORGANIC POLYMER BY A LASER DRIVEN SHOCK WAVE" JOURNAL OF APPLIED PHYSICS, Bd. 73, Nr. 10, 15. Mai 1993 (1993-05-15), Seiten 5292-5294, XP002159626 New York, USA
- MAKROPOULOU M I ET AL: "VIS AND UV LASER ABLATION OF POLYMERS" SECOND GR-I INTERNATIONAL CONFERENCE ON NEW LASER TECHNOLOGIES AND APPLICATIONS, OLYMPIA, GREECE, 1-4 JUNI 1997, PROCEEDINGS OF THE SPIE, Bd. 3423, 1998, Seiten 384-388, XP000866592 The International Society for Optical Engineering, USA
- "WIRESTRIPPING PROCEDURE USING VISIBLE LASER RADIATION AND DYE-DOPED INSULATION" IBM TECHNICAL DISCLOSURE BULLETIN,US,IBM CORP. NEW YORK, Bd. 34, Nr. 12, 1. Mai 1992 (1992-05-01), Seite 378 XP000308558 ISSN: 0018-8689

## Beschreibung

Aus der EP-A-0 164 564 ist es bekannt, in einem Laminat mit der Schichtenfolge Metall-Dielektrikum-Metall mit Hilfe eines Excimer-Lasers Sacklöcher zu erzeugen. Die oberste Metallschicht des Laminats wird hierbei als Lochmaske verwendet, deren Lochbild mittels Phototechnik übertragen und durch nachfolgendes Ätzen hergestellt wird. Das im Lochbereich dieser Maske freiliegende Dielektrikum wird dann durch die Einwirkung des Excimer-Lasers abgetragen, bis die unterste Metallschicht erreicht ist und den Abtragungsprozess beendet. Mit dem bekannten Verfahren werden insbesondere bei der Herstellung mehrlagiger Leiterplatten die erforderlichen Durchkontaktierungslöcher in Form von Sacklöchern hergestellt.

Aus der DE-Z "Feinwerktechnik & Messtechnik 91 (1983) 2, S. 56-58 ist ein ähnliches Verfahren zur Herstellung mehrlagiger Leiterplatten bekannt, bei welchem die als Durchkontaktierungen dienenden Sacklöcher mit Hilfe eines CO₂-Lasers erzeugt werden. Auch hier dient die oberste Kupferfolie als Lochmaske, bei der überall dort, wo der Laserstrahl ein Loch erzeugen soll, das Kupfer weggeätzt wird.

Aus der DE-A-197 19 700 sind auch bereits Einrichtungen zum Laserbohren von Laminaten bekannt, bei welchen zum Bohren der Metallschichten ein erster Laser mit einer Wellenlänge im Bereich von etwa 266 nm bis 1064 nm und zum Bohren der Dielektrikumsschichten ein zweiter Laser mit einer Wellenlänge im Bereich von etwa 1064 nm bis 10600 nm eingesetzt werden.

Aus der US-A-5 593 606 ist ein Verfahren zum Laserbohren von Laminaten bekannt, bei welchem zum Bohren der Metallschichten und zum Bohren der Dielektrikumsschichten ein einziger UV-Laser eingesetzt wird, dessen Wellenlängen unter 400 nm liegen und dessen Pulsbreiten unter 100 ns liegen. Unter der Voraussetzung, dass kein Excimer-Laser verwendet wird, werden also Metall und organisches Material mit dem gleichen UV-Laser gebohrt.

Aus der DE-A-198 24 225 ist ein weiteres Verfahren zum Laserbohren von Laminaten bekannt, bei welchem zum Bohren der Metallschichten und zum Bohren der Dielektrikumsschichten beispielsweise auch ein SHG (zweite harmonische Generation)-YAG-Laser mit einer Wellenlänge von 532 nm oder ein THG (dritte harmonische Generation)-YAG-Laser mit einer Wellenlänge von 355 nm eingesetzt werden können.

Grundsätzlich kann festgestellt werden, dass beim Laserbohren von organischen Materialien mit UV-Lasern, das heißt mit Wellenlängen unterhalb 400 nm, eine photochemische Zersetzung der organischen Materialien stattfindet. Hier kommt es also zu keinen Verbrennungen und aufgrund der allenfalls äußerst geringen thermischen Belastung kommt es bei Laminaten zu keiner Delamination. Im Gegensatz dazu findet beim Laserbohren von organischen Materialien mit CO₂-Lasern eine thermische Zersetzung der organischen Materialien statt, das heißt es kann zu Verbrennungen kommen und bei Laminaten besteht die Gefahr einer Delamination. Im Vergleich zu UV-Lasern können mit CO₂-Lasern beim Bohren von organischen Materialien jedoch erheblich kürzere Bearbeitungszeiten erzielt werden.

Der in den Ansprüchen 1 und 13 angegebenen Erfindung liegt das Problem zugrunde, beim Laserbohren von Laminaten, die mindestens eine Metallschicht und mindestens eine Dielektrikumsschicht aus einem organischen Material aufweisen, eine rasche Herstellung von Sack- oder Durchgangslöchern ohne Beschädigung der Laminate zu ermöglichen.

Der Erfindung liegt die Erkenntnis zugrunde, dass mit frequenzverdoppelten Nd-Vanadate-Lasern mit einer Wellenlänge von 532 nm bei kurzen Pulsbreiten unter 40 ns sowohl die Metallschichten als auch die Dielektrikumsschichten effektiv bearbeitet werden können. Dabei werden für das Laserbohren der Metallschichten Pulsfrequenzen ≥ 30 kHz gewählt, während für das Laserbohren der Dielektrikumsschichten Pulsfrequenzen ≥ 20 kHz gewählt werden. Durch die Wahl höherer Pulsfrequenzen für die Bearbeitung der organischen Materialien ergibt sich eine besonders effektive Laserbearbeitung beider Materialarten. Bei der Laserbearbeitung der organischen Materialien ergibt sich eine Kombination von photochemischer und thermischer Zersetzung, die im Vergleich zu UV-Lasern kürzere Bearbeitungszeiten ermöglicht und im Vergleich zu CO₂-Lasern zu hohe thermische Belastungen vermeidet.

Der für das Bohren von Laminaten erfindungsgemäß ausgewählte frequenzverdoppelte ND-Vanadate-Laser ermöglicht sehr hohe Pulsfrequenzen, die sogar über 100 kHz liegen können bei geringen Pulsbreiten von weniger als 40 ns. Die hohen Pulsfrequenzen ermöglichen dabei eine rasche und effektive Bearbeitung der Laminate, während durch die niedrigen Pulsbreiten eine sehr niedrige thermische Belastung gewährleistet wird. Mit anderen Lasern, die mit ähnlichen oder gleichen Wellenlängen arbeiten, kann eine derartige Kombination von hohen Pulsfrequenzen und kurzen Pulsbreiten nicht realisiert werden. So können beispielsweise bei dem aus der DE-A-198 24 225 bekannten SHG-YAG-Laser bei höheren Pulsfrequenzen allenfalls Pulsbreiten von 70 bis 80 ns erzielt werden.

Vorteilhafte Ausgestaltungen des erfindungsgemäßen Verfahrens gehen aus den Ansprüchen 2 bis 12 hervor.

Die Ausgestaltung nach Anspruch 2 ermöglicht durch Pulsbreiten von weniger als 30 ns eine noch geringere thermische Belastung der Laminate beim Laserbohren.

Bei Verwendung eines fokussierten Laserstrahls mit einem Spotdurchmesser zwischen 10 µm und 100 µm gemäß Anspruch 3 ergibt sich eine effektive Laserbearbeitung von Metall und organischem Material. Bei Verwendung von Spotdurchmessern zwischen 20 µm und 50 µm gemäß Anspruch 4 kann die Laserbearbeitung beider Materialien noch effektiver gestaltet werden.

Die Ausgestaltung nach Anspruch 5 ermöglicht durch die höhere Absorption der Laserstrahlen im organischen Material eine erhebliche Steigerung der Bearbeitungsgeschwindigkeit. Die Zusatzstoffe sollen dabei einen deutlich höheren Absorptionsgrad für Laserstrahlen mit einer Wellenlänge von 532 nm aufweisen als das reine organische Material.

Die Weiterbildung nach Anspruch 6 ermöglicht eine besonders einfache und wirtschaftliche Steigerung des Absorptionsgrades des organischen Materials.

Die Ausgestaltung nach Anspruch 7 ermöglicht durch die Auswahl von roten Zusatzstoffen eine Optimierung des Absorptionsgrades, da das grüne Licht der Wellenlänge 532 nm durch die Komplementärfarbe Rot besonders gut absorbiert wird.

Die Weiterbildung nach Anspruch 8 gibt für die Beimengung von Pigmenten als Zusatzstoff einen Mengenbereich an, der sich zur Steigerung des Absorptionsgrades ohne Beeinträchtigung der sonstigen Eigenschaften besonders gut bewährt hat. Der in Anspruch 9 angegebene engere Mengenbereich ist dabei als optimal anzusehen.

Wird der Absorptionsgrad des organischen Materials durch die Beimengung von Zusatzstoffen gemäß Anspruch 10 auf mindestens 50 % gesteigert, so ergibt sich bereits eine beträchtliche Steigerung der Bearbeitungsgeschwindigkeit im organischen Material. Bei einer Steigerung des Absorptionsgrades auf mindestens 60 % gemäß Anspruch 11 bzw. auf mindestens 80% gemäß Anspruch 12 können die Bearbeitungszeiten für das Laserbohren des organischen Materials entsprechend weiter verringert werden.

In den nachfolgend beschriebenen Beispielen wurden die folgenden Lasertypen eingesetzt:

### Laser I:

Diodengepumpter, frequenzverdoppelter Nd-Vanadate-Laser der Firma Spectra Physics, Mountain View, California, US.

| | |
|---|---|
| Bezeichnung | T80-YHP40-532QW |
| Wellenlänge | 532 nm |
| Leistung | ca. 8,5 W |
| Betriebsart | Monomode TEMoo |
| Pulsbreite | 20 ns bei Pulsfrequenz 10 kHz |
| Pulsfrequenz | bis 200 kHz |
| Feldgröße | 100x100 mm². |

### Laser II:

Diodengepumpter, frequenzverdoppelter Nd-Vanadate-Laser der Firma Haas-Laser GmbH, Schramberg, DE.

| | |
|---|---|
| Bezeichnung | keine, da Prototype |
| Wellenlänge | 532 nm |
| Leistung | ca. 4,0 W |
| Betriebsart | Monomode TEMoo |
| Pulsbreite | 25 ns bei Pulsfrequenz 10 kHz |
| Pulsfrequenz | bis 200 kHz. |
| Feldgröße | 100x100 mm² |

Mit den Lasern I und II wurden die folgenden Materialien bearbeitet:

### Material I:

Ein RCC-Material (RCC = Resin Coated Copper Foil) wird auf ein beidseitig mit Kupferfolie beschichtetes, glasfaserverstärktes FR4-Material (FR4 = level 4 fire retardant epoxyglass composition) auflaminiert. Es ergibt sich eine Schichtenfolge mit einer 12 µm starken Kupferfolie einer 60 µm starken Schicht aus unverstärktem Epoxy-Material, einer 16 µm starken Kupferfolie, einer 1 mm starken Schicht aus glasfaserverstärktem Epoxy-Material und einer 16 µm starken Kupferfolie.

### Material II:

Auf ein 60 µm starkes FR4-Material sind beidseitig jeweils 12 um starke Kupferfolien auflaminiert.
Zur Modifikation der vorstehend geschilderten Materialien I und II standen folgende Zusatzstoffe zur Verfügung:

### Zusatzstoff I:

Organisches rotes Pigment mit der Bezeichnung "1501 Fast Red" (C.I. Pigment Red 48:1) der Firma Xijingming, Shenzhou City, Hebei Province, P.R. China. Es handelt sich um ein Azo-Pigment auf der Basis eines Bariumsalzes.

### Zusatzstoff II:

Anorganisches rotes Pigment mit der Bezeichnung "Bayferrox™" (C.I. Pigment Rot 101) der Bayer AG, DE. Es handelt sich um ein Eisenoxidrotpigment.

### Zusatzstoff III:

Polymerlöslicher Antrachinon-Farbstoff mit der Bezeichnung "Oracet™ Gelb GHS (C.I. Solvent Gelb 163) der CIBA-Geigy AG, CH.

### Zusatzstoff IV:

Fasern eines Rubinglases, das durch Zusatz von 2 Gew.-% Selen, 1 Gew.-% Cadmiumsulfid, 1 Gew.-% Arsentrioxid und 0,5 Gew.-% Kohle zu einem Grundglas der Zusammensetzung NA₂O-ZnO-4SiO₂ hergestellt wurde

### Beispiel 1:

Mit dem Laser I wurden in die obere, 12 µm starke Kupferfolie und die 60 µm starke Dielektrikumsschicht aus unverstärktem Epoxy-Material des Materials I Sacklöcher mit einem Durchmesser von 125 µm eingebracht. Die Pulsfrequenz betrug 45 kHz für das Bohren der Kupferschicht und 25 kHz für das Bohren der µDielektrikumsschicht. Die Pulslänge betrug 30 ns.

Bei Verwendung von zwei Galvanometerspiegeln zur Ablenkung des Laserstrahls in x-Richtung und in y-Richtung wurde eine Fläche von 10 cm x 10 cm bearbeitet. Mit einem Spotdurchmesser des fokussierten Laserstrahls von ca. 25 µm wurde der Laserstrahl zum Kupferbohren im äußeren Lochbereich in wenigen konzentrischen Kreisen bewegt, wobei dann der innere Bereich der Kupferfolie von selbst ausgeworfen wird. Der Durchmesser des äußeren konzentrischen Kreises betrug dabei 110 µm. Die Lineargeschwindigkeit des Laserstrahls betrug 900 mm/s. Zum Bohren des Epoxy-Materials wurde der Laserstrahl 1,6 mm außer Fokus gestellt (OOF = Out of Focus), wobei aber auch hier konzentrische Kreise beschrieben wurden. Nach dem Durchbohren des Epoxy-Materials wurde die darunterliegende Kupferfolie nur geringfügig angegriffen.

Das Bohren der Kupferfolie erfolgte mit einer Geschwindigkeit von 289 Löchern pro Sekunde, während das Bohren des Epoxy-Materials mit einer Geschwindigkeit von 220 Löchern pro Sekunde erfolgte. Das Einbringen der Sacklöcher in das Laminat erfolgte somit mit einer Geschwindigkeit von 120 Löchern pro Sekunde.

### Beispiel 2:

Abweichend vom Beispiel 1 wurde der Laser II mit den gleichen Laserparametern eingesetzt. Das Bohren der Kupferfolie erfolgte hier mit einer Geschwindigkeit von 145 Löchern pro Sekunde, während das Bohren des Epoxy-Materials mit einer Geschwindigkeit von 122 Löchern pro Sekunde erfolgte. Das Einbringen der Sacklöcher in das Laminat erfolgte somit mit einer Geschwindigkeit von 65 Löchern pro Sekunde.

### Beispiel 3:

Abweichend vom Beispiel 1 wurden die Sacklöcher in das Material II eingebracht. Die Ergebnisse waren vergleichbar.

### Beispiel 4:

Abweichend vom Beispiel 2 wurden die Sacklöcher in das Material II eingebracht. Die Ergebnisse waren vergleichbar.

### Beispiel 5:

Abweichend vom Beispiel 1 wurden Sacklöcher mit einem Durchmesser von 100 µm hergestellt. Das Bohren der Kupferfolie erfolgte mit einer Geschwindigkeit von 398 Löchern pro Sekunde, während das Bohren des Epoxy-Materials mit einer Geschwindigkeit von 382 Löchern pro Sekunde erfolgte. Das Einbringen der Sacklöcher in das Laminat erfolgte somit mit einer Geschwindigkeit von 183 Löchern pro Sekunde.

### Beispiel 6:

Abweichend vom Beispiel 2 wurden Sacklöcher mit einem Durchmesser von 100 µm hergestellt. Das Bohren der Kupferfolie erfolgte mit einer Geschwindigkeit von 199 Löchern pro Sekunde, während das Bohren des Epoxy-Materials mit einer Geschwindigkeit von 212 Löchern pro Sekunde erfolgte. Das Einbringen der Sacklöcher in das Laminat erfolgte somit mit einer Geschwindigkeit von 99 Löchern pro Sekunde.

### Beispiel 7:

Abweichend vom Beispiel 1 wurden Sacklöcher mit einem Durchmesser von 75 µm hergestellt. Das Bohren der Kupferfolie erfolgte mit einer Geschwindigkeit von 750 Löchern pro Sekunde, während das Bohren des Epoxy-Materials mit einer Geschwindigkeit von 800 Löchern pro Sekunde erfolgte. Das Einbringen der Sacklöcher in das Laminat erfolgte somit mit einer Geschwindigkeit von 300 Löchern pro Sekunde.

### Beispiel 8:

Abweichend vom Beispiel 2 wurden Sacklöcher mit einem Durchmesser von 75 µm hergestellt. Das Bohren der Kupferfolie erfolgte mit einer Geschwindigkeit von 370 Löchern pro Sekunde, während das Bohren des Epoxy-Materials mit einer Geschwindigkeit von 400 Löchern pro Sekunde erfolgte. Das Einbringen der Sacklöcher in das Laminat erfolgte somit mit einer Geschwindigkeit von 150 Löchern pro Sekunde.

### Beispiel 9:

Abweichend vom Beispiel 1 wurde ein modifiziertes Material I verwendet, bei welchem dem unverstärkten Epoxy-Material ca. 1,5 Gew.-% des Zusatzstoffes I beigemengt wurden. Die Geschwindigkeit für das Bohren des Epoxy-Materials konnte durch die verbesserte Absorption der Laserstrahlung auf 550 Löcher pro Sekunde gesteigert werden. Die Geschwindigkeit für das Einbringen der Sacklöcher in das Laminat konnte um ca. 50 % auf etwa 180 Löcher gesteigert werden.

### Beispiel 10:

Abweichend vom Beispiel 9 wurden dem unverstärkten Epoxy-Material ca. 1,5 Gew.-% des Zusatzstoffes II beigemengt. Die Ergebnisse waren vergleichbar.

### Beispiel 11:

Abweichend vom Beispiel 9 wurden dem unverstärkten Epoxy-Material ca. 1,5 Gew.-% des Zusatzstoffes III beigemengt. Die Steigerung der Geschwindigkeit für das Bohren des Epoxy-Materials fiel hier etwas geringer aus.

### Beispiel 12:

Abweichend vom Beispiel 9 wurde der Laser II mit den gleichen Laserparametern eingesetzt. Die Geschwindigkeit für das Bohren des Epoxy-Materials konnte auf 306 Löcher pro Sekunde gesteigert werden.

### Beispiel 13:

Abweichend vom Beispiel 9 wurden Sacklöcher mit einem Durchmesser von 100 µm hergestellt. Die Geschwindigkeit für das Bohren des Epoxy-Materials betrug 956 Löcher pro Sekunde.

### Beispiel 14:

Abweichend vom Beispiel 12 wurden Sacklöcher mit einem Durchmesser von 100 µm hergestellt. Die Geschwindigkeit für das Bohren des Epoxy-Materials betrug 531 Löcher pro Sekunde.

### Beispiel 15:

Abweichend vom Beispiel 3 wurde ein modifiziertes Material II verwendet, bei welchem das FR4-Material als Epoxy-Material ausgebildet war, das anstelle der üblichen Glasfaserverstärkung mit ca. 50 Gew.-% Fasern des Zusatzstoffes IV verstärkt war. Die Geschwindigkeit für das Bohren dieses Epoxy-Materials konnte um einen Faktor zwischen 2 und 2,5 gesteigert werden.

Anstelle der in den Beispielen 1 bis 15 angegebenen Sacklöcher können selbstverständlich auch Durchgangslöcher hergestellt werden. Das Bohren der unteren Kupferfolie erfolgt in diesem Fall unter den gleichen Bedingungen und mit dem gleichen Zeitaufwand wie das Bohren der oberen Kupferfolie.

## Patentansprüche

1. Verfahren zum Laserbohren von Laminaten, die mindestens eine Metallschicht und mindestens eine Dielektrikumsschicht aus einem organischen Material aufweisen, **gekennzeichnet durch** die Verwendung eines frequenzverdoppelten Nd-Vanadate-Lasers mit folgenden Laserparametern:
- Pulsbreite < 40 ns
- Pulsfrequenz ≥ 30 kHz für die Metallschicht
≥ 20 kHz für die Dielektrikumsschicht
- Wellenlänge = 532 nm.

2. Verfahren nach Anspruch 1, **dadurch gekennzeichnet, dass** eine Pulsbreite < 30 ns verwendet wird.

3. Verfahren nach Anspruch 1 oder 2, **dadurch gekennzeichnet, dass** ein fokussierter Laserstrahl mit einem Spotdurchmesser zwischen 10 µm und 100 µm verwendet wird.

4. Verfahren nach Anspruch 3, **dadurch gekennzeichnet, dass** ein fokussierter Laserstrahl mit einem Spotdurchmesser zwischen 20 µm und 40 µm verwendet wird.

5. Verfahren nach einem der vorhergehenden Ansprüche, **dadurch gekennzeichnet, dass** dem organischen Material Zusatzstoffe beigemengt werden, die einen höheren Absorptionsgrad für Laserstrahlen mit einer Wellenlänge von 532 nm als das reine organische Material aufweisen.

6. Verfahren nach Anspruch 5, **dadurch gekennzeichnet, dass** als Zusatzstoff mindestens ein anorganisches und/oder organisches Pigment und/oder mindestens ein polymerlöslicher Farbstoff und/oder mindestens ein faserförmiger Füllstoff verwendet wird.

7. Verfahren nach Anspruch 6, **dadurch gekennzeichnet, dass** als Zusatzstoff mindestens ein anorganisches rotes Pigment und/oder ein organisches rotes Pigment und/oder ein polymerlöslicher roter Farbstoff verwendet wird.

8. Verfahren nach Anspruch 6 oder 7, **dadurch gekennzeichnet, dass** dem organischen Material zwischen 0,1 Gew.-% und 5,0 Gew.-% Pigmente beigemengt werden.

9. Verfahren nach Anspruch 6 oder 7, **dadurch gekennzeichnet, dass** dem organischen Material zwischen 1 Gew.-% und 2 Gew.-% Pigmente beigemengt werden.

10. Verfahren nach einem der Ansprüche 5 bis 9, **dadurch gekennzeichnet, dass** das organische Material durch die Beimengung der Zusatzstoffe einen Absorptionsgrad von mindestens 50 % für die Wellenlänge 532 nm der Laserstrahlung aufweist.

11. Verfahren nach einem der Ansprüche 5 bis 9, **dadurch gekennzeichnet, dass** das organische Material durch die Beimengung der Zusatzstoffe einen Absorptionsgrad von mindestens 60 % für die Wellenlänge 532 nm der Laserstrahlung aufweist.

12. Verfahren nach einem der Ansprüche 5 bis 9, **dadurch gekennzeichnet, dass** das organische Material durch die Beimengung der Zusatzstoffe einen Absorptionsgrad von mindestens 80 % für die Wellenlänge 532 nm der Laserstrahlung aufweist.

13. Einrichtung zum Laserbohren von Laminaten, die mindestens eine Metallschicht und mindestens eine Dielektrikumsschicht aus einem organischen Material aufweisen, mit einem frequenzverdoppelten Nd-Vanadate-Laser mit folgenden Laserparametern:
- Pulsbreite < 40 ns
- Pulsfrequenz ≥ 30 kHz für die Metallschicht
≥ 20 kHz für die Dielektrikumsschicht
- Wellenlänge = 532 nm.

## Claims

1. Method for the laser drilling of laminates which have at least one metal layer and at least one dielectric layer comprising an organic material, **characterized by** the use of a frequency-doubled Nd vanadate laser having the following laser parameters:
- Pulse width < 40 ns
- Pulse frequency ≥ 30 kHz for the metal layer
≥ 20 kHz for the dielectric layer
- Wavelength = 532 nm.

2. Method according to Claim 1, **characterized in that** a pulse width of < 30 ns is used.

3. Method according to Claim 1 or 2, **characterized in that** a focused laser beam with a spot diameter of between 10 µm and 100 µm is used.

4. Method according to Claim 3, **characterized in that** a focused laser beam with a spot diameter of between 20 µm and 40 µm is used.

5. Method according to one of the preceding claims, **characterized in that** additives which have a higher absorptance for laser beams with a wavelength of 532 nm than the organic material alone are admixed with the organic material.

6. Method according to Claim 5, **characterized in that** at least one inorganic and/or organic pigment and/or at least one polymer-soluble dye and/or at least one fibrous filler is used as additive.

7. Method according to Claim 6, **characterized in that** at least one inorganic red pigment and/or an organic red pigment and/or a polymer-soluble red dye is used as additive.

8. Method according to Claim 6 or 7, **characterized in that** between 0.1% by weight and 50% by weight of pigments are admixed with the organic material.

9. Method according to Claim 6 or 7, **characterized in that** between 1% by weight and 2% by weight of pigments are admixed with the organic material.

10. Method according to one of Claims 5 to 9, **characterized in that** the organic material, on account of the admixed additives, has an absorptance of at least 50% for the wavelength 532 nm of the laser radiation.

11. Method according to one of Claims 5 to 9, **characterized in that** the organic material, on account of the admixed additives, has an absorptance of at least 60% for the wavelength 532 nm of the laser radiation.

12. Method according to one of Claims 5 to 9, **characterized in that** the organic material, on account of the admixed additives, has an absorptance of at least 80% for the wavelength 532 nm of the laser radiation.

13. Device for the laser drilling of laminates which have at least one metal layer and at least one dielectric layer comprising an organic material, using a frequency-doubled Nd vanadate laser having the following laser parameters:
- Pulse width < 40 ns
- Pulse frequency ≥ 30 kHz for the metal layer
≥ 20 kHz for the dielectric layer
- Wavelength = 532 nm.

## Revendications

1. Procédé pour percer des laminés au laser, lesdits laminés présentant au moins une couche de métal et au moins une couche diélectrique constituée par un matériau organique, **caractérisé par** l'utilisation d'un laser vanadate Nd double fréquence dont les paramètres laser sont les suivants:
- durée d'impulsion < 40 ns
- fréquence de pulsation ≥ 30 kHz pour la couche de métal
≥ 20 kHz pour la couche diélectrique
- longueur d'onde = 532 nm.

2. Procédé selon la revendication 1, **caractérisé par** l'utilisation d'une durée d'impulsion < 30 ns.

3. Procédé selon la revendication 1 ou 2, **caractérisé par** l'utilisation d'un rayon laser focalisé, le diamètre de focalisation étant compris entre 10 µm et 100 µm.

4. Procédé selon la revendication 3, **caractérisé par** l'utilisation d'un rayon laser focalisé, le diamètre de focalisation étant compris entre 20 µm et 40 µm.

5. Procédé selon l'une des revendications précédentes, **caractérisé par** l'adjonction d'adjuvants au matériau organique, lesquels présentent un degré d'absorption de rayons laser ayant une longueur d'onde de 532 nm supérieur à celui du matériau organique pur.

6. Procédé selon la revendication 5, **caractérisé par** l'utilisation en tant qu'adjuvant d'au moins un pigment inorganique et/ou organique et/ou d'au moins un colorant soluble dans des polymères et/ou d'au moins une matière de charge se présentant sous forme de fibres.

7. Procédé selon la revendication 6, **caractérisé par** l'utilisation, en tant qu'adjuvant, d'au moins un pigment rouge inorganique et/ou d'un pigment rouge organique et/ou d'un colorant rouge soluble dans des polymères.

8. Procédé selon la revendication 6 ou 7, **caractérisé par** l'adjonction de pigments au matériau organique, comprise entre 0,1 % en poids et 5,0% en poids de pigments.

9. Procédé selon la revendication 6 ou 7, **caractérisé par** l'adjonction de pigments au matériau organique, comprise entre 1 % en poids et 2 % en poids de pigments .

10. Procédé selon l'une des revendications 5 à 9, **caractérisé en ce que** le matériau organique présente, suite à l'adjonction des adjuvants, un degré d'absorption d'au moins 50 % pour la longueur d'onde de 532 nm du rayonnement laser.

11. Procédé selon l'une des revendications 5 à 9, **caractérisé en ce que** le matériau organique présente, suite à l'adjonction des adjuvants, un degré d'absorption d'au moins 60 % pour la longueur d'onde de 532 nm du rayonnement laser.

12. Procédé selon l'une des revendications 5 à 9, **caractérisé en ce que** le matériau organique présente, suite à l'adjonction des adjuvants, un degré d'absorption d'au moins 80 % pour la longueur d'onde de 532 nm du rayonnement laser.

13. Dispositif pour percer des laminés au laser, lesdits laminés présentant au moins une couche de métal et au moins une couche diélectrique constituée par un matériau organique, comprenant un laser vanadate Nd double fréquence dont les paramètres laser sont les suivants:
- durée d'impulsion < 40 ns
- fréquence de pulsation ≥ 30 kHz pour la couche de métal
≥ 20 kHz pour la couche diélectrique
- longueur d'onde = 532 nm.
